# EUROPEAN PATENT APPLICATION

(11) **EP 0 841 757 A1**
(43) Date of publication of application: **13.05.1998**
(21) Application number: 95936801.0
(22) Date of filing: 24.07.1995
(51) Int. Cl.: H04B 1/64

(54) **COMPANDER-TYPE DYNAMIC NOISE SUPPRESSION DEVICE**

(71) Applicant: Pavlov, Gennady Alexandrovich, Moscow, 105203 (RU)
(72) Inventor: Pavlov, Gennady Alexandrovich, Moscow, 105203 (RU)
(74) Representative: Quintelier, Claude
(86) International application number: RU9500158
(87) International publication number: WO9704535

(57) **Abstract**

The proposed compander-type dynamic noise suppression device comprises the following elements connected in series: a compressor connected via a noise feed unit, a dynamic noise limitation unit and an expander. The noise suppression device can operate across the sound frequency spectrum or in individual bands within that spectrum. The dynamic noise limitation unit causes additional noise reduction in breaks in the entire sound spectrum or particular spectrum bands.

## Description

The invention deals with the field of accumulation of information and the systems of noise suppression in sound replaying technique in particular.

The compander-type noise suppression device which comprises the units of compressor and expander connected via a noise feed unit (e.g. recording tape) is widely known 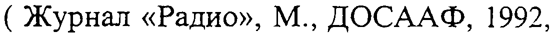 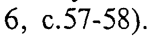 Similar systems DOLBY-A, B, C, SR and DBX ensure masking the noises by sound signals, i.e. with the availability of a sound the noises are not perceived.

Noises are mainly perceived by hearing during the breaks between musical fragments or isolated sounds, especially in case of using in multi-channel tape-recorders when there are durable breaks between sound signals.

The known devices comprise two main units - compressor and expander - made in the form of non-linear amplifiers. 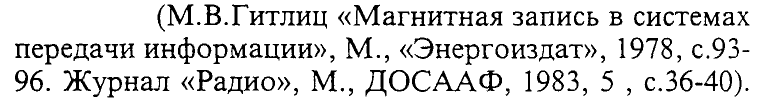 Such systems ensure such level of noises which is 10 dB lower than the natural level of sounding. At the peak level of a sound the noise isn't perceived due to masking by the sound.

However, the known systems do not ensure sufficient level of noise suppression.

The aim of the given invention is to create such a device which comprises a compander-type and dynamic noise suppression devices and changes in the given mode the form of the signal's bending line as well as simplifies the execution of such device.

The invention is illustrated by a diagram.Fig.1 represents the structure of the device,Fig.2 and Fig.3 show the temporal diagrams of the signals of the known compander-type noise reduction device and those of the compander-type dynamic noise reduction device accordingly.

The compander-type dynamic noise suppression device comprises a compressor (Unit No1) connected via a noise feed unit No 2 (e.g. recording/replaying channels of the analogue tape-recorder) with a dynamic noise limitation unit No 3, the outlet of which is connected to the inlet of an expander (Unit No 4) which restores the sound signals to the original levels.

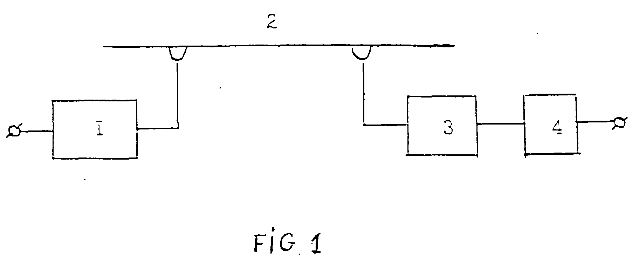

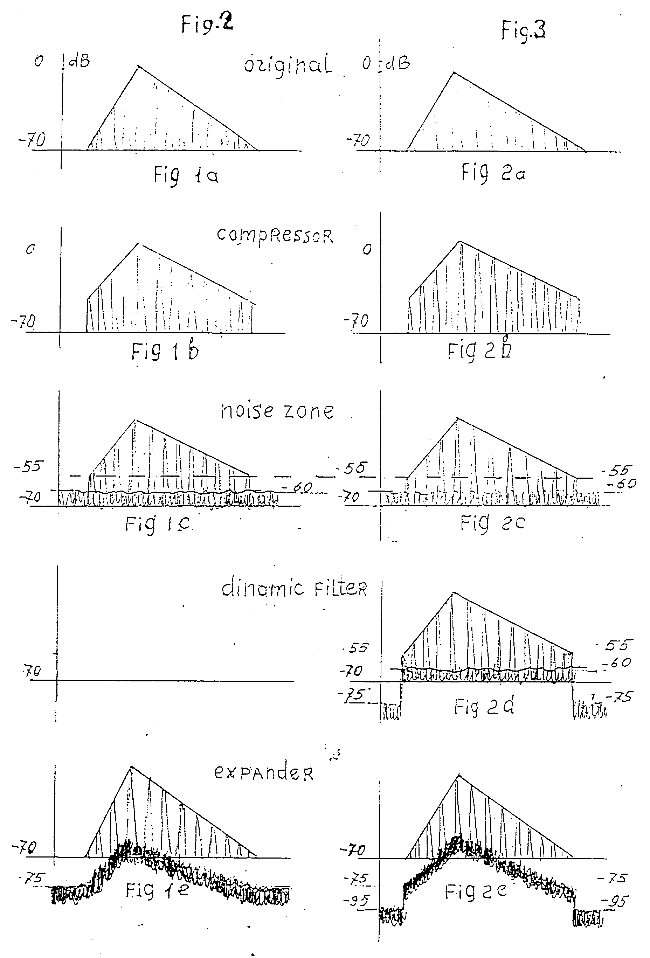

For the sake of convenience, let's assume that the beginning and the end of the sound signal are approximately at the level of -65 dB(Fig.2a). While passing through the compressor with amplifying (e.g. 15 dB) the levels of the beginning and the end of the signal encrease to -50 dB; as this takes place the form of the bending line changes(Fig. 2b). Then the signal goes through a noise feed unit, e.g., it is recorded on a recording tape (Fig. 2c). As seen from Fig.4, in the known compander-type noise suppression device the levels of the beginning and the end of the sound lies 10 dB higher than the noise level.

In an ordinary compander-type noise suppression device the signal goes through the expander which restores it to the initial state (Fig. 2e). In this case a 10 dB gain in noise is obtained in breaks.

The compander-type dynamic noise suppression device operates in the following way.

The initial signal (Fig.3a) after passing through the compressor (Fig.3b) and recording on a recording tape (Fig. 3 c) gets from the recording head /which isn't shown/ to the dynamic filter 3, which lets in signals of about - 55dB and higher without distortion (open) and diminishes signals lower than -55dB by 15 dB (closed) (Fig. 3d). After that the signal cleared in breaks gets to the expander (Fig.3e), in this case the levels of the sound are restored to the initial state and the level of noises is lowered by another 15 dB in comparison with the compander-type noise suppression device. In the result, before the beginning of the sound signals the level of noise suppression averages about 90 dB.
In the new structure called PGF the processing of the signals can be made across the whole sound frequency spectrum similar to the DbX system as well as in individual bands within that spectrum similar to systems «Dolby BNR, Dolby C or Dolby A».

In the result the gain of -15dB in breaks between sound signals is obtained and can be considerably encreaesed in comparison with ordinary compander-type noise suppression devices (Fig. 2).

The device is especially efficient while using in multi-channel tape-recorders where there are durable enough breaks between replaying signals in individual channels. In this case DNL filters and non-linear amplifiers can be correspondingly optimized to ensure the given levels of noise suppression.

It should be noted that some DNL devices which ensure noise suppression in a definite band (see above) are already known. Operational amplifiers in such devices have a great amplifiying coefficient which is chosen according to the amplitude of noises and the degree of compressing/expanding.

However, at the present time there remains unknown a technical solution which uses the combination of the known noise suppression devices for solving the task of considerable decrease of noise levels, for example in breaks while using in multi-channel tape-recorders.

As it is illustrated above the compander-type dynamic noise suppression device has a dynamic noise limitation unit with the sensitivity, for example, -55dB which follows the noise feed unit, i.e. while there is no signal at the level of -60 dB it is closed and decreases the noises approximately by 15 dB to the level of -75 dB, while with the appearing of the signal at the level of about -55dB it opens and lets in the signal without distortion and after finishing the signal it is closed again.

All this ensures efficient usage of a combined compander-type and dynamic noise suppression devices in the given technical solution.

## Claims

1. Compander-type dynamic noise suppression device comprises a compressor the outlet of which is connected with a noise feed unit and an expander and **distinguishes** by including a dynamic noise limitation unit which is connected between a noise feed unit and an inlet of the expander.

2. A compander-type dynamic noise suppression device (1) **distinguishes** by the fact that it allows to operate across the whole sound frequency spectrum or in individual bands within that spectrum.
